# EUROPEAN PATENT APPLICATION

(11) **EP 1 052 312 A1**
(43) Date of publication of application: **15.11.2000**
(21) Application number: 00303291.9
(22) Date of filing: 18.04.2000
(51) Int. Cl.: C30B 11/00, C30B 29/60, G03F 7/00

(54) **Melt-infiltration process for fabricating article exhibiting substantial three-dimensional order and resultant article**

(30) Priority: 14.05.1999 US 312165
(71) Applicant: LUCENT TECHNOLOGIES INC., Murray Hill, New Jersey 07974-0636 (US)
(72) Inventor: Vannes Braun, Paul, Berkeley Heights, New Jersey 07922 (US); Wiltzius, Pierre, Millington, New Jersey 07946 (US)
(74) Representative: Johnston, Kenneth Graham

(57) **Abstract**

A structure, e.g., a photonic band gap material, is provided exhibiting substantial periodicity on a micron scale, along with desirable density and mechanical integrity. A template comprising a colloidal crystal is provided, and into the interstitial space of the crystal is introduced a molten material. The introduction is typically performed and/or promoted by subjecting the crystal and molten material to a pressurized environment, which tends to force the molten material through the interstitial space of the crystal. The material is cooled, and the colloidal crystal particles are typically removed, e.g., by heating, etching, or dissolving. The resulting material constitutes a highly uniform, high-density structure, due to the invention's use of a continuous liquid phase to fill the void volume, as opposed to techniques that result in porosity and non-uniformities within the final structure.

## Description

### BACKGROUND OF THE INVENTION

### Field of the Invention

The invention relates to structures exhibiting three-dimensional periodicity, for example structures useful for photonic applications.

### Discussion of the Related Art

Recently, there has been increasing interest in periodic dielectric structures, also referred to as photonic crystals (PC), in particular, photonic crystals exhibiting gaps in photonic band structures (referred to as photonic band gap (PBG) materials), for numerous photonic applications. See, e.g., P.S.J. Russell, "Photonic Band Gaps," Physics World, 37, August 1992; I. Amato, "Designing Crystals That Say No to Photons," Science, Vol. 255, 1512 (1993); and U.S. Patents Nos. 5,600,483 and 5,172,267, the disclosures of which are hereby incorporated by reference. PBG materials exhibit a photonic band gap, analogous to a semiconductor's electronic band gap, that suppress propagation of certain frequencies of light, thereby offering, for example, photon localization or inhibition of spontaneous emissions. A PC is generally formed by providing a high refractive index dielectric material with a three-dimensional lattice of cavities or voids having low refractive index. Photons entering the material concentrate either at the high-index regions or the low-index regions, depending on the particular energy of the photon, and the photonic band gap exists for photons of a particular energy between the two regions. Photons having energy within the PBG cannot propagate through the material, and their wave function thereby decays upon entering the material. The photonic band structure, therefore, depends on the precision of the physical structure and on its refractive index, and some difficulty has arisen in fabricating such materials. Specifically, it has been difficult to organize a three-dimensional lattice with periodicities of a micron scale, particularly with high refractive index materials. (Periodicities on a micron scale, as used herein, indicate that a structure contains repeating units, the repetition occurring at a distance falling within the range 0.1 µm to 100 µm.)

In one approach, reflected in the above-cited U.S. Patents, solid materials are provided with numerous holes by mechanical techniques, e.g., drilling, or lithographic techniques, e.g., etching. This approach has provided useful results, but is limited by the ability of current processing technology to provide the necessary structure. Drilling, for example, is not capable of providing periodicity on a micron scale. And lithography, for example, generally does not provide an article having sufficient dimensionality in all three dimensions.

In another approach, ordered colloidal suspensions or sediments of relative low refractive index particles such as silica or polystyrene, referred to as colloidal crystals, are used as templates for infiltration or deposition of high refractive index materials in a desired structure, and the particles are then etched away or burned out to provide the voids. See, e.g., B.T. Holland et al., "Synthesis of Macroporous Minerals with Highly Ordered Three-Dimensional Arrays of Spheroidal Voids," Science, Vol. 281, 538 (July 1998); E.G. Judith et al., "Preparation of Photonic Crystals Made of Air Spheres in Titania," Science, Vol. 281, 802 (July 1998); and A.A. Zakhidov et al., "Carbon Structures with Three-Dimensional Periodicity at Optical Wavelengths," Science, Vol. 282, 897 (October 1998). The infiltration/deposition has been performed, for example, by an alkoxide sol-gel technique and by chemical vapor deposition. The results attained thus far have been interesting, but are far from providing a commercially feasible product. Specifically, the infiltration/deposition of the high refractive index material tends to be insufficient (e.g., low density leading to low refractive index) and non-uniform. For example, during alkoxide sol-gel deposition and CVD, some voids near the outside of the crystal become clogged, such that gelation/deposition at interior voids is inhibited. Moreover, insufficient and inadequate infiltration create voids within the high index material, causing substantial shrinkage, and thus cracking, during removal of the template material.

Improvements over these previous processes are reflected in co-assigned U.S. patent applications serial nos. 09/248,858 and 09/248,577 (our reference Braun 1 and Braun 2, respectively). Further improvements and alternatives are being sought, however.

### SUMMARY OF THE INVENTION

The process of the invention provides a structure, e.g., a photonic band gap material, exhibiting substantial periodicity on a micron scale, the process providing desirable density and mechanical integrity. (Periodicity, as used herein indicates that the structure is composed of a three-dimensional periodic array of repeated units. See, e.g., N.W. Ashcroft et al., Solid State Physics, 64, W.B. Saunders Co. (1976).) The process involves the steps of providing a template comprising a colloidal crystal, and introducing into the interstitial voids of the crystal a molten material. The introduction is typically performed and/or promoted by subjecting the crystal and molten material to a pressurized environment, which tends to force the molten material through the voids in the crystal. The material is cooled, and the colloidal crystal particles are typically removed, e.g., by heating, etching, or dissolving. The resulting material constitutes a highly uniform, high-density structure. This desirable structure is due to the invention's use of a continuous liquid phase to fill the void volume, as opposed to techniques that result in porosity and non-uniformities within the final structure.

### BRIEF DESCRIPTION OF THE DRAWINGS

Fig. 1 illustrates a structure according to the invention having substantial periodicity on a micron scale.
Fig. 2 illustrates a structure according to the invention having substantial periodicity on a micron scale.

### DETAILED DESCRIPTION OF THE INVENTION

The process of the invention involves the steps of providing a template comprising a colloidal crystal, and introducing, i.e., infiltrating, into the interstitial voids of the crystal a molten material. The infiltration is typically performed and/or promoted by subjecting the crystal and molten material to a pressurized environment. The pressure tends to push the molten material through substantially all the voids in the crystal. The material is cooled, and the colloidal crystal particles are typically removed, e.g., by heating, etching, or dissolving. The resultant structure is a lattice of the previously-molten material containing a periodic array of voids reflecting the crystal template.

Colloidal crystals are periodic structures typically formed from small particles suspended in solution. It is possible to form them by allowing slow sedimentation of substantially uniformly-sized particles in a liquid, such that the particles arrange themselves in a periodic manner. Other fabrication techniques are also possible. For photonic band gap applications, the average particle diameter typically ranges from about 100 nm to about 5 µm. A variety of sizes are possible, however, depending on the desired structure and use of the final product. It is possible to form colloidal crystals from any suitable materials. Examples include polystyrene, polymethylmethacrylate, and silica. Polystyrene and other organics are easily removed after formation of the final structure by heating or dissolving with appropriate solvent. Silica particles are easily removed by acid etching, e.g., by HF.

The lattice structure of colloidal sediments generally exhibits two-dimensional periodicity, but not necessarily substantial three-dimensional periodicity. Specifically, sedimentation of the colloidal particles induces a random stacking with the close-packed planes perpendicular to gravity. Such a randomly-stacked structure does not exhibit substantial three-dimensional periodicity, because of the randomness in the gravity direction. It is possible that such materials will be suitable for some applications, e.g., filters and catalysts. However, for many PBG applications, it is desired to have materials exhibiting substantial three-dimensional periodicity. One way to do so is to use colloidal epitaxy to form the template crystal, as discussed in A. van Blaaderen et al., "Template-directed colloidal crystallization," Nature, Vol. 385, 321 (January 1997), the disclosure of which is hereby incorporated by reference. Colloidal epitaxy involves growing a colloidal crystal normal to an underlying pattern, e.g., a series of holes, reflecting a particular three-dimensionally ordered crystal, e.g., the (100) plane of a face-centered cubic (FCC) crystal. The holes order the first layer of settling colloidal particles in a manner that controls the further sedimentation.

Nearly any molten material is suitable for use with the invention, depending on the application of the resultant ordered structure. For example, for photonic band gap applications, materials such as Ge, Te, along with Se, As₂Se₃ and other chalcogenide glasses are useful. Polymeric materials are suitable for other applications, as are molten salts. Materials having relatively low melting points are attractive from a practical standpoint, but any material capable of being introduced into a colloidal crystal in molten form is possible.

Once the colloidal sediment or crystal is formed, as discussed above, the material to be melted is typically simply placed on top of the crystal, e.g., in powder or pellet form. The temperature is raised to at least the melting point of the material - generally higher to attain a desirably low viscosity. (It is also possible to first melt a material and then combine the molten material and the crystal.) The molten material is then introduced into the crystal by appropriate techniques, these techniques varying depending on the properties of the molten material and the crystal.

Generally, it is advantageous to apply a vacuum to the crystal, to evacuate the interstitial voids, and then subject the crystal and molten material to a pressurized environment, to force the molten material into the voids of the crystal. Without the pressure, it is possible that the melt will non-uniformly or inadequately fill the interstitial voids in the colloidal crystal. The level of pressure required depends on a variety of factors, including the viscosity of the melt, the relative wetting properties of the melt and the crystal, and the void/colloidal particle size in the crystal. For example, better wetting by the melt will generally result in less pressure being required to attain desired infiltration. In addition, it is possible to adjust the relative wetting of the melt and the colloidal crystal, such as by modifying the surfaces of the colloidal crystal to induce wetting, or by including additives in the melt. In the specific case where the molten material wets the crystal to a very high degree, it is possible that simply allowing the molten material time to work its way through the crystal will be adequate to attain a useful structure, but for the typical case, pressure is desirable.

Once the melt infiltration is performed to the desired extent, the resultant material is cooled. A significant feature of the invention is that the existence and size of voids in the cooled, introduced material are capable of being controlled. One technique for void control is the amount of applied pressure. Specifically, the extent to which the molten material wets the surface area of the colloidal particles around the contact point of adjacent colloidal particles is proportional to how much pressure is pushing the molten material into the crevice near that contact point. Another technique is to sinter a colloidal crystal such that adjacent particles are joined, as opposed to merely in contact, with one another. Such joining also has an effect on the flow of the molten material, and thus on the existence and size of voids in the final structure of introduced material. It is possible to control void formation in the final structure by using sintering and pressure techniques independently or together.

It is possible to use a fast quench, e.g., 50°C per minute, particularly for chalcogenide glasses and for materials in which crystallization is desirably avoided. In other materials, such as polymers, the cooling rate tends to be less significant. In addition, materials that undergo significant contraction upon solidification will tend to introduce some voids into the final structure.

The invention is thus able to provide a highly uniform, high-density structure due to the substantially complete filling of the interstitial voids of the crystal by the continuous liquid phase. In particular, it is possible to attain a high level of filling of the interstitial voids, e.g., 100 vol.%, using the process of the invention (as measured post-cooling). (100 vol.% indicates that 100 vol.% falls within the experimental error range of the technique used to measure the extent of filling.) Typically, at least a small portion of the final structure of the introduced material, e.g., a portion falling within the experimental error range of typical measurement techniques - such as 0.5 vol.%, is made up of voids, which allows the colloidal crystal particles to be removed (e.g., by allowing liquid etchant to enter and gaseous or liquid material to exit). However, if removal of the colloidal crystal particles is not desired, it is possible to have all of the interstitial voids filled by the final structure. The invention thus allows formation of an interconnected lattice surrounding a periodic array of voids, where the voids have a periodicity on a micron scale, and where the lattice material itself comprises up to 100% solid material. Increased amounts of voids within the lattice material are capable of being provided as described above, but typically the lattice material will comprise at least 80 vol.% solid material.

The composite material is then typically treated to remove the colloidal particles. In the case of inorganic materials, a suitable etchant is generally applied, e.g., exposure of silica to HF. In the case of organics, the composite is typically treated with an organic solvent to dissolve the colloidal particles. It is also possible to apply heat to burn out the organics. Other techniques are also possible, such as irradiation or plasma-assisted etching of the organic material. (In some applications the presence of the colloidal crystal material may be acceptable.)

The ordered structure is useful for a variety of photonic applications, including optical filters, optical switches, waveguides, routers, laser cavities and other photonic band gap applications. Particular design considerations for PBG materials are known in the art, as reflected for example in J.D. Joannopoulos et al., Photonic Crystals, Princeton University Press (1995), the disclosure of which is hereby incorporated by reference. Other applications include filters, catalysts, and biocompatible materials.

The invention will be further clarified by the following examples, which are intended to be exemplary.

### Example 1

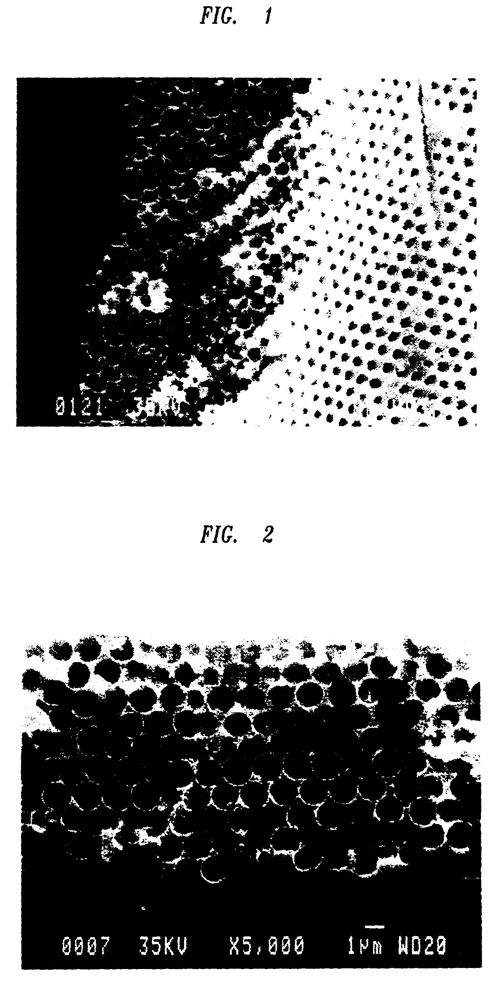

A colloidal crystal was formed by sedimentation of 1 µm silica onto a glass substrate from a 0.4% by weight solution of silica colloid in 80% ethanol and 20% xylene. After the xylene and ethanol solution evaporated, the resulting dry colloidal crystal was heated to 400 °C at 10 °C/min and held for 30 minutes. The crystal, located on the glass substrate, was then placed into the bottom of a vial, and 6 grams of selenium powder was placed on top of the crystal. The vial containing the colloidal crystal and selenium was then placed into a high pressure cell. The pressure cell was first evacuated and then heated to 275 °C, melting the selenium. The temperature of 275 °C was maintained for a few minutes, and then the pressure cell was pressurized to 1000 psi, forcing the selenium liquid into the interstitial space of the colloidal crystal. After 5 minutes, the cell was quenched in ice water. Once the temperature of the cell was about 25°C (which took less than 5 minutes), the pressure in the cell was released, and the sample removed. The vial was broken away from the resulting structure, which was then placed into a 5% HF solution to dissolve the colloidal crystal. Fig. 1 is a scanning electron micrograph of the resulting structure.

### Example 2

A highly oriented colloidal crystal was formed by sedimentation of 1.6 µm silica onto a patterned silicon substrate from a solution consisting of 160 µl hydrazine, 10 µl 0.137 M LiCl, 20 µl H₂O, 10 µl 2.5% polyvinyl alcohol in H₂O, and 50 µl 2 wt.% 1.6 um silica colloid in water. The substrate pattern was a square array of 0.81 µm holes on a 1.6 µm pitch. After the liquid evaporated, the resulting dry colloidal crystal was heated to 400 °C at 10 °C/min and held for 30 minutes. The crystal, located on the silicon substrate, was then placed into the bottom of a vial, and 6 grams of selenium powder was placed on top of the crystal. The vial containing the colloidal crystal and selenium was then placed into a high pressure cell. The pressure cell was first evacuated and then heated to 275 °C, melting the selenium. After the temperature of 275 °C was maintained for a few minutes, the pressure cell was pressurized to 1000 psi, forcing the selenium liquid into the interstitial space of the colloidal crystal. After 5 minutes, the cell was quenched in ice water. Once the temperature of the cell was about 25°C (which took less than 5 minutes), the pressure in the cell was released, and the sample removed. The vial was broken away from the material, which was then placed into a 5% HF solution to dissolve the colloidal crystal. Fig. 2 is a scanning electron micrograph of the resulting structure.

Other embodiments of the invention will be apparent to those skilled in the art from consideration of the specification and practice of the invention disclosed herein.

## Claims

1. A process for fabricating an article comprising a material exhibiting substantial periodicity, the process comprising the steps of:
providing a template comprising a colloidal crystal;
introducing into the interstitial voids of the crystal a molten material;
cooling the molten material; and
removing the colloidal crystal.

2. The process of claim 1, wherein the step of introducing the molten material comprises subjecting the molten material and the colloidal crystal to a pressurized environment.

3. The process of claim 2, wherein the pressure applied is proportional to a desired void content in the cooled, introduced material.

4. The process of claim 1, wherein a vacuum is applied to the colloidal crystal prior to introducing the molten material.

5. The process of claim 1, wherein the material exhibiting substantial periodicity exhibits a photonic band gap.

6. The process of claim 1, wherein the molten material comprises a material selected from Ge, Te, chalcogenide glasses, and polymeric materials.

7. The process of claim 1, wherein the periodicity is of a micron scale.

8. The process of claim 1, wherein the cooled, introduced material fills at least 99 vol.% of the interstitial voids.

9. A process for fabricating an article comprising a material exhibiting substantial periodicity, the process comprising the steps of:
providing a template comprising a colloidal crystal;
introducing into the interstitial voids in the crystal a molten material; and
cooling the molten material to form the material exhibiting substantial periodicity.

10. The process of claim 9, wherein the step of introducing the molten material comprises subjecting the molten material and the colloidal crystal to a pressurized environment.

11. The process of claim 9, wherein a vacuum is applied to the colloidal crystal prior to introducing the molten material.

12. The process of claim 9, wherein the molten material comprises a material selected from Ge, Te, chalcogenide glasses, and polymeric materials.

13. An article comprising a material exhibiting substantial periodicity, the material comprising an interconnected lattice structure surrounding a periodic array of voids, wherein the voids have a periodicity of a micron scale, and wherein the lattice structure comprises at least 80 vol.% solid material.

14. The article of claim 13, wherein the lattice structure comprises 100 vol.% solid material.

15. The article of claim 13, wherein the material exhibiting substantial periodicity exhibits a photonic band gap.
